Europäisches Patentamt

European Patent Office

Office européen des brevets

(19)

(11) **EP 1 198 062 A2**

(12) **EUROPÄISCHE PATENTANMELDUNG**

(43) Veröffentlichungstag:
**17.04.2002 Patentblatt 2002/16**

(51) Int Cl.[7]: **H03G 7/00**

(21) Anmeldenummer: **01440336.4**

(22) Anmeldetag: **08.10.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **11.10.2000 DE 10050150**

(71) Anmelder: **ALCATEL**
**75008 Paris (FR)**

(72) Erfinder: **Walker, Michael**
**73666 Baltmannsweiler 2 (DE)**

(74) Vertreter: **KOHLER SCHMID + PARTNER**
**Patentanwälte**
**Ruppmannstrasse 27**
**70565 Stuttgart (DE)**

(54) **Dynamikreduzierung für dynamikbegrenzte Audiosysteme**

(57)     Ein Verfahren zur Begrenzung der Dynamik von Audiosignalen bei Audio-Endgeräten, bei dem ein Eingangssignal x derart behandelt wird, dass ein festgelegter maximaler Grenzwert $y_{max}$ für ein Ausgangssignal y aus dem Endgerät nicht überschritten wird, und bei dem ein vorgebbarer konstanter Verstärkungswert v eingestellt wird, wobei für v ≤ 1 das Eingangssignal x mit einem Nominalpegel mit maximaler Amplitude ≤ $y_{max}$ verzerrungsfrei als Ausgangssignal y wiedergegeben wird, und wobei für v = const > 1 eine Verzerrung der Signale auftritt, ist dadurch gekennzeichnet, dass in einem ersten Schritt (a) das Eingangssignal x in seiner Dynamik auf einen Zwischenwert $y_1$ < x komprimiert wird, und dass in einem darauf folgenden zweiten Schritt (b) das mit dem konstanten Verstärkungswert v verstärkte Ausgangssignal y = v · $y_1$ gebildet wird. Dadurch können mit einfachen Mitteln Verzerrungen im Ausgangssignal y auch für hohe Verstärkungen v erheblich vermindert, minimiert oder gänzlich ausgeschlossen werden.

Fig. 1a

EP 1 198 062 A2

**Beschreibung**

Die Erfindung betrifft ein Verfahren zur Begrenzung bzw. Reduktion der Dynamik von Audiosignalen, insbesondere menschlichen Sprachsignalen, bei Audio-Endgeräten, insbesondere bei Telekommunikations (=TK)-Endgeräten für die Übertragung von akustischen Nutzsignalen, bei dem ein Eingangssignal x derart behandelt wird, dass ein festgelegter maximaler Grenzwert $y_{max}$ für ein Ausgangssignal y aus dem Endgerät nicht überschritten wird, und bei dem ein vorgebbarer konstanter Verstärkungswert v eingestellt wird, wobei für $v \leq 1$ das Eingangssignal x mit einem Nominalpegel mit maximaler Amplitude $\leq y_{max}$ verzerrungsfrei als Ausgangssignal y wiedergegeben wird, und wobei für $v = const > 1$ eine Verzerrung der Signale auftritt.

Ein solches Verfahren ist beispielsweise durch das sogenannte "Hard Clipper"-Prinzip bekannt.

Nach dem Hard Clipper-Prinzip, wie es in Fig. 1b dargestellt ist, werden die Audiosignale hart auf einen festen Wert begrenzt.

Die Begrenzung tritt bei der Analogtechnik meist durch die Begrenzung der verfügbaren Versorgungsspannung auf oder wird mittels einer Begrenzerschaltung auf einen festen Wert eingestellt. Bei der digitalen Signalverarbeitung müssen die digitalen Abtastwerte auf einen maximal darstellbaren Wert begrenzt werden, um einen Zahlenüberlauf zu verhindern. Durch die harte Begrenzung treten hörbare Verzerrungen auf, die Sprachqualität und die Verständlichkeit werden verschlechtert.

Bei der Aufzeichnung von Audiosignalen auf Magnetbändern ist der Dynamikumfang durch die physikalischen Eigenschaften des Bandmaterials eingeschränkt. Bei dem bekannten DOLBY-Verfahren wird vor der Aufzeichnung auf ein Magnetband eine Dynamikkompression mit festem Kompressionsgrad durchgeführt. Die Aufzeichnung wird dann nach dem Lesen vom Magnetband wieder auf die ursprüngliche Dynamik mittels Dynamikexpander gebracht. Kompressionsgrad und Expansionsgrad heben sich gegenseitig auf. Damit ergeben sich allerdings folgende Nachteile: Eine feste Kompression ändert die Lautstärke im gesamten Dynamikbereich und führt zum "Atmen". Ziel sollte es jedoch sein den gesamten Bereich möglichst naturgetreu zu übertragen. Eine automatische Anpassung an den zur Verfügung stehenden Dynamikbereich fehlt aber beim DOLBY-Verfahren.

Verfahren zur Dynamikreduzierung von digitalen Audiosignale mit a-law oder μ-law Kompressionskennlinien sind nach dem Standard ITU-T G721 bekannt. Sie dienen zur Datenreduktion auf 64 kBit/s. Die Dynamik wird hierbei um 6Bit entsprechend 36 dB vor der Übertragung komprimiert, und nach der Übertragung wieder mit der gleichen Kennlinie dekomprimiert.

Diese Verfahren sind insofern nachteilig, da jeder einzelne Abtastwert entsprechend der nichtlinearen Funktion der Kennlinie verzerrt wird, was zu starken hörbaren Verzerrungen im Ausgangssignal y führt.

Aufgabe der vorliegenden Erfindung ist es demgegenüber, ein Verfahren der eingangs beschriebenen Art mit möglichst einfachen Mitteln dahingehend weiterzubilden, dass Verzerrungen im Ausgangssignal y auch für hohe Verstärkungen v erheblich vermindert, wenn möglich minimiert oder gänzlich ausgeschlossen werden.

Erfindungsgemäß wird diese Aufgabe auf ebenso überraschend einfache wie wirkungsvolle Art und Weise dadurch gelöst, dass in einem ersten Schritt (a) das Eingangssignal x in seiner Dynamik auf einen Zwischenwert $y_1 < x$ komprimiert wird, und dass in einem darauffolgenden zweiten Schritt (b) das mit dem konstanten Verstärkungswert v verstärkte Ausgangssignal $y = v \cdot y_1$ gebildet wird.

Der Verstärkungswert v dient zur Lautstärkeeinstellung und ist so definiert, dass v=1 der Vollaussteuerung eines Signals entspricht, wobei v>1 zu Verzerrungen eines Signals mit Nominalpegel führt.

Sprachsignale weisen Pegelschwankungen auf, die durch die individuelle Betonung des Sprechers hervorgerufen werden. Diese leisen und lauten Passagen müssen nun unterschiedlich behandelt werden, um für alle Passagen eine maximale und verzerrungsfreie Verstärkung zu erreichen.

Demgegenüber soll die Signalform des Sprachsignals möglichst naturgetreu übertragen werden. Die Signalform ist abhängig vom Sprachinhalt (Vokal, Konsonant etc...).

Mit $y_1$ wird nun erfindungsgemäß ein Zwischenwert aus dem Eingangssignal x berechnet, der bei der anschließenden Verstärkung v verzerrungsfreie Signale liefert. Hierzu muss die Dynamik des Eingangssignals x auf einen vom Szenario abhängigen Wert komprimiert werden. Der erforderliche Kompressionsgrad oder die erforderliche Schwelle ab der das Signal komprimiert wird ist vom Signalinhalt von x und von der eingestellten Verstärkung v abhängig. Die Art der Kompression kann individuell gestaltet werden.

Besonders bevorzugt ist eine Variante des erfindungsgemäßen Verfahrens, bei der ein Zwischenwert $y_1$ gebildet wird aus $y_1 = x \, f(cf)$, wobei $f(cf)$ eine Funktion eines dynamischen Verstärkungsfaktors cf ist, der in Abhängigkeit vom Eingangssignal x und dem konstanten Verstärkungswert v berechnet wird.

Zur Bildung des Zwischenwertes wird das Eingangssignal x auf einen von der Verstärkung v abhängigen Wert reduziert, um bei der anschließenden Multiplikation mit cf Verzerrungen durch Übersteuerung zu vermeiden.

Eine Weiterbildung dieser Verfahrensvariante sieht vor, dass aus dem Eingangssignal x ein Kurzzeitmittelwert sam(x) gebildet wird, und dass für $v \leq 1$ der dynamische Verstärkungsfaktor cf berechnet wird als

$$cf = 1/v,$$

für v > 1 der dynamische Verstärkungsfaktor cf berechnet wird als

$$cf = 1/(v^2 \cdot sam(x))$$

und daraus jeweils der Zwischenwert y1 = x · f(cf) gebildet wird.

Durch die Verwendung der Kurzzeitmittelwerte sam(x) zur Berechnung des aktuellen Verstärkungsfaktors cf ist eine nahezu verzerrungsfreie Pegelkontrolle möglich.

Einzelne Abtastwerte werden stationär betrachtet und mit annähernd gleichem Verstärkungsgrad behandelt. Dadurch werden hörbare Signalformverzerrungen vermieden, während das System sich sehr schnell an Pegelschwankungen anpasst.

Für einzelne Abschnitte erscheint das System stabil, wobei trotzdem schnelle Systemschwankungen fast unhörbar ausgeglichen werden können. Grund dafür ist die Verwendung der an das Ohr angepassten sam - Mittelung .

Bei Systemen mit unterabgetasteten Hilfsgrößen ist diese Lösung einfacher, da keine sonstigen konditionalen Operationen notwendig sind.

Eine Vereinfachung dieser Verfahrensvariante sieht vor, dass das Ausgangssignal y direkt aus dem Eingangssignal x und dem Verstärkungswert v berechnet wird, wenn v < 1

$$y = v * x$$

Sonst wird

$$cf = 1/(v^2 \cdot sam(x))$$

und daraus jeweils das Ausgangssignal y = x · f(cf) gebildet wird.

Besteht keine Übersteuerungsgefahr, kann das Ausgangssignal direkt aus x und v berechnet werden. Ein Vorteil dieser Vorgehensweise ist, dass keine Beeinflussung des Signals bei Verstärkungswerten v<1 stattfindet.

Bei einer anderen Weiterbildung der oben genannten Verfahrensvariante ist vorgesehen, dass aus dem Eingangssignal x ein Kurzzeitmittelwert sam(x) gebildet wird, und dass

für abs(x) ≥ 1/v der dynamische Verstärkungsfaktor cf berechnet wird als cf = 1/v,
für abs(x) < 1/v der dynamische Verstärkungsfaktor cf berechnet wird als cf = $1/( v^2 \cdot sam(x)^n)$,
    wobei $|n| \in \aleph \neq 0$

und daraus jeweils das Ausgangssignal y1 = x·f(cf) gebildet wird. Damit lässt sich der Kompensationsgrad durch das erfindungsgemäße Verfahren innerhalb relativ weiter Grenzen frei festlegen.

Bei einer besonders einfachen Realisierung dieser Weiterbildung wird der Exponent n = 1 gewählt.

Bei einer weiteren, besonders bevorzugten Ausführungsform des erfindungsgemäßen Verfahrens wird die Funktion f(cf) derart gewählt, dass sie eine Filterung, insbesondere eine Glättung des dynamischen Verstärkungsfaktors cf bewirkt.

Bei einer besonders effektiven und einfach zu handhabenden Weiterbildung dieser Ausführungsform ist die Funktion f(cf) ein rekursives Filter erster Ordnung für cf.

Die Glättung ist in allen Fällen, in denen keine Übersteuerung vorliegt, sinnvoll und reduziert den Klirrfaktor.

Speziell kann diese Weiterbildung noch dadurch verbessert werden, dass das Eingangssignal x in äquidistanten Zeitschritten T jeweils zu Zeitpunkten k mit einer Abtastfrequenz $f_A$ = 1/T abgetastet wird, und dass die Funktion f(cf) als geglätteter Verstärkungswert cg(k) berechnet wird gemäß

$$f(cf) = cg(k) = \begin{cases} cf & \text{für } sam(x) > 1/v \\ cf(k) \cdot as + cg(k-1) \cdot bs & \text{für } cf < cg \\ cf(k) \cdot al + cg(k-1) \cdot bl & \text{für } cf \geq cg \end{cases}$$

wobei $as = 1 - bs = 1 - e^{-T/\tau_k}$, mit einer Zeitkonstanten $\tau_k < t_{max}$
und $al = 1 - bl = 1 - e^{-T/\tau_l}$, mit einer Zeitkonstanten $\tau_l > t_{min}$.

Durch diese zustandsabhängige Filterung wird eine schnelle Unterdrückung von Übersteuerungen bei großen Dynamiksprüngen erreicht, während für normale Situationen die Zeitfunktion des Glättungsfilters an das Ohr angepasst ist und für eine verzerrungsfreie Wiedergabe sorgt.

Weiter ist es vorteilhaft, wenn dabei die Teilfunktionen im Verfahren zur Berechnung des geglätteten dynamischen Verstärkungswertes cg mit einer niedrigeren Abtastfrequenz als $f_A$ berechnet werden, um Rechenleistung einzusparen.

Die entsprechenden Zeitgrenzwerte werden zur Erzielung eines gehöradäquaten Zeitverhaltens vorteilhafter Weise als $t_{max} \leq 1$ ms und $t_{min} \geq 60$ ms, vorzugsweise $t_{min} \geq 65$ ms gewählt.

Bei einer alternativen Weiterbildung umfasst die Funktion f(cf)

$$\text{eine Integration } f(cf) = \int cf \cdot dt$$

oder

$$\text{eine Summation } f(cf) = K^{-1} \cdot \sum_{k=0}^{K-1} cf(k) \quad \text{mit } K = T/\tau_m$$

über cf.

Besonders bevorzugt ist auch eine Verfahrensvariante, bei der der Kurzzeitmittelwert sam(x) an das Wahrnehmungsverhalten des menschlichen Ohres gemäß den Regeln der Psychoakustik angepasst ist.

Bei einer weiteren Verfahrensvariante ist es vorteilhaft, wenn das Eingangssignal x in äquidistanten Zeitschritten T jeweils zu Zeitpunkten k mit einer Abtastfrequenz $f_A = 1/T$ abgetastet wird, und dass die der Kurzzeitmittelwert sam(x(k)) berechnet wird gemäß

$$sam(x(k)) = \begin{cases} x(k) \cdot \alpha s + sam(x(k-1)) \cdot \beta s & \text{für } x(k) > sam(x(k)) \\ x(k) \cdot \alpha l + sam(x(k-1)) \cdot \beta l & \text{für } x(k) \leq sam(x(k)) \end{cases}$$

wobei $\alpha s = 1 - \beta s = 1 - e^{-T/\tau_k}$, mit einer Zeitkonstanten $\tau_k < t_{max}$
und $\alpha l = 1 - \beta l = 1 - e^{-T/\tau_l}$, mit einer Zeitkonstanten $\tau_l > t_{min}$.

Dabei werden die Zeitgrenzwerte bevorzugt wieder zu $t_{max} \leq 1$ ms und $t_{min} \geq 60$ ms, vorzugsweise $t_{min} \geq 65$ ms gewählt.

In den Rahmen der vorliegenden Erfindung fällt auch eine Servereinheit, eine Prozessor-Baugruppe sowie eine Gate-Array-Baugruppe zur Unterstützung des oben beschriebenen erfindungsgemäßen Verfahrens sowie ein Computerprogramm zur Durchführung des Verfahrens. Das Verfahren kann sowohl als Hardwareschaltung, als auch in Form eines Computerprogramms realisiert werden. Heutzutage wird eine Software-Programmierung für leistungsstarke DSP's bevorzugt, da neue Erkenntnisse und Zusatzfunktionen leichter durch eine Veränderung der Software auf bestehender Hardwarebasis implementierbar sind. Verfahren können aber auch als Hardwarebausteine beispielsweise in TK-Endgeräten oder Telefonanlagen implementiert werden.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

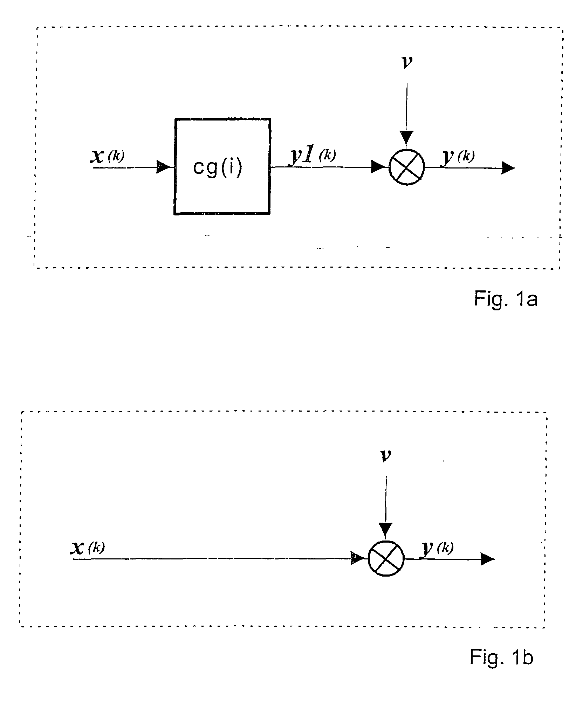

Fig. 1a     ein stark schematisiertes Prinzipbild der Funktionsweise einer Einrichtung zur Durchführung des erfindungsgemäßen Verfahrens;

Fig. 1 b     ein entsprechendes Prinzipbild für den Stand der Technik;

Fig. 2a     Ausgangssignalpegel y als Funktion des Eingangssignals x für verschiedene Verstärkungswerte v beim erfindungsgemäßen Verfahren;

Fig. 2b     wie Fig. 2a, aber nach dem Stand der Technik;

Fig. 3a     das Modulationsverhalten eines stark ausgesteuerten Sprachsignals nach der Behandlung mit dem erfindungsgemäßen Verfahren; und

Fig. 3b     das Modulationsverhalten desselben Sprachsignals nach der Behandlung mit einem Verfahren nach dem Stand der Technik.

Ziel des erfindungsgemäßen Verfahrens ist die Begrenzung bzw. Reduktion der Dynamik von Audiosignalen, insbesondere menschlichen Sprachsignalen, bei allen Anwendungen, bei denen eine Begrenzung der Übertragungsdynamik gegeben ist.

So ist die verzerrungsfreie Wiedergabe von Sprachsignalen mit kleinen Lautsprechersystemen oder bei Endgeräten mit begrenzter Versorgungsspannung (batteriebetriebene Geräte) nur in einem begrenzten Aussteuerbereich möglich. Gefordert wird allerdings häufig mehr Lautstärke, als vom System abgegeben werden kann, um beispielsweise leise Passagen in einer geräuscherfüllten Umgebung noch hörbar zu machen. Dies ist allerdings nur durch eine Reduzierung des Dynamikbereichs möglich.

<u>Figur 1a</u> zeigt das Prinzip der Erfindung. Das Ausgangssignal y(k) wird hier nach Gleichung (1) wie folgt berechnet:

$$y(k) = v \cdot y_1(k) \tag{1}$$

$y_1(k)$ ist das dynamikreduzierte Eingangssignal und wird nach Gleichung (2) wie folgt berechnet:

$$y_1(k) = \begin{cases} x(k) & \text{falls } v \leq 1 \\ \\ x(k) \cdot f(cf(m)) & \text{falls } v > 1 \end{cases} \tag{2}$$

Die Fallentscheidung in Gleichung (2) kann auch schon früher erfolgen. So kann die Fallunterscheidung wie in Gleichung (1b) durchgeführt werden, wodurch sich die Berechnung von $y_1(k)$ wie folgt vereinfacht und der bestmögliche Störabstand erreicht werden kann:

$$y(k) = \begin{cases} x(k) \cdot v & \text{falls } v \leq 1 \\ v \cdot y_1(k) & \text{falls } v > 1 \end{cases} \qquad (1b)$$

$$y_1(k) = x(k) \cdot f(cf) \qquad (2b)$$

Mit $y_1(k)$ wird ein dynamisch kontrolliertes Signal berechnet, das verzerrungsfrei mit der gewünschten Verstärkung verstärkt werden kann. Die Dynamikkompression wird durch einen gemittelten Kompressionsfaktor $cf(m)$ erreicht, der nach Gleichung (3) wie folgt berechnet werden kann:

$$cf(m) = \begin{cases} 1/v & \text{falls } |x(k)| < 1/v \\ 1/(v^2 \cdot sam(x)) & \text{falls } |x(k)| \geq 1/v \end{cases} \qquad (3)$$

Der Index m weist zeigt an, dass dieser Wert unterabgetastet werden kann. Die Mittelung von $cf(m)$ kann, wie in der folgenden Gleichung (4) gezeigt, erreicht werden:

$$cg_{(m)} = f(cf_{(m)}) = \begin{cases} cf & f\ddot{u}r\left(|x_{(k)}| > \dfrac{\cdot 1}{V}\right) \\ cf(m) \cdot as + cg(m) \cdot bs & f\ddot{u}r \ cf_{(m)} < cg_{(m)} \\ cf(m) \cdot al + cg(m) \cdot bl & f\ddot{u}r \ cf_{(m)} > cg_{(m)} \end{cases} \qquad (4).$$

Es werden zwei Zeitkonstanten verwendet. Die Koeffizienten as und bs stehen für eine kurze Zeitkonstante und al und bl für eine lange.

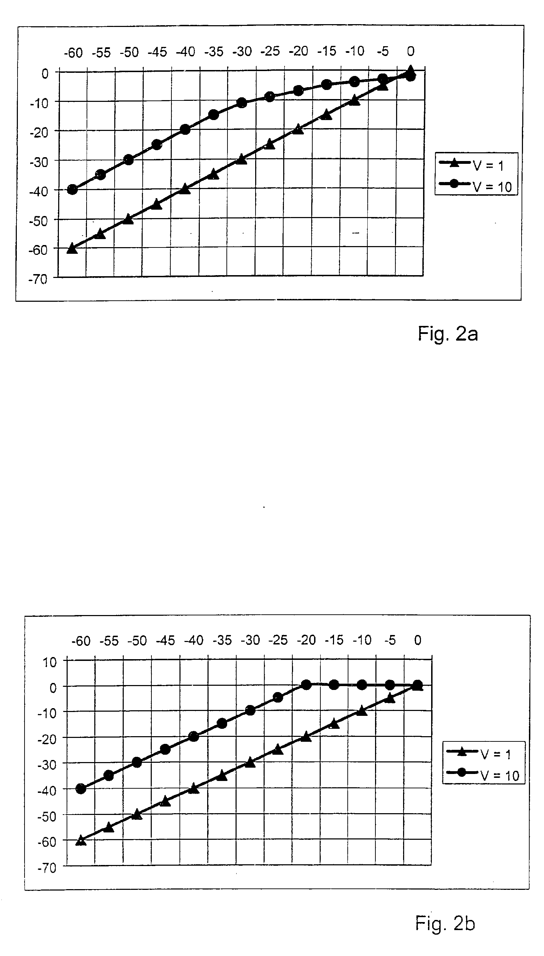

Figur 2a zeigt die Wirkungsweise der Erfindung bei v=1 und v=10. Deutlich ist die Krümmung ab etwa -35dB zu erkennen, ab der die Kompression des Signals mit zunehmendem Eingangspegel zunimmt.

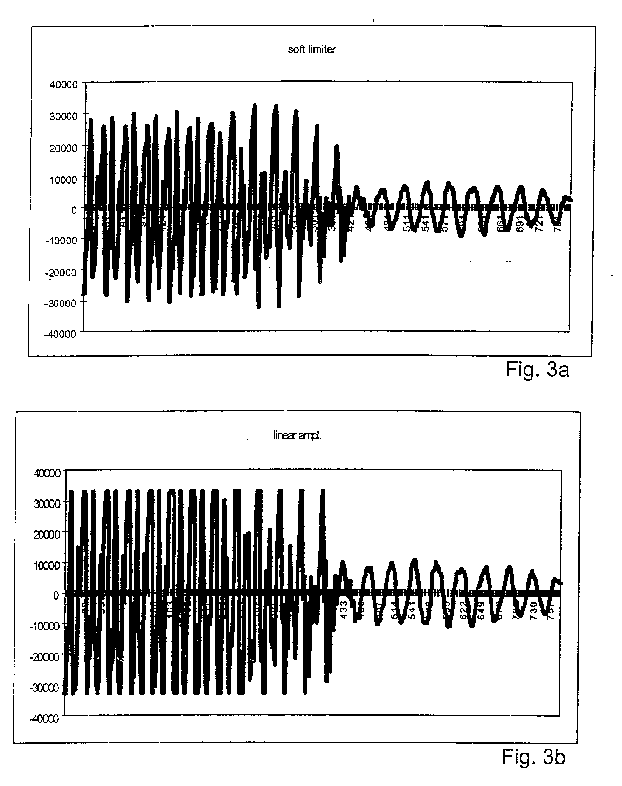

Figur 3a zeigt die Wirkungsweise der Erfindung im Zeitsignal. Durch die Kompression wird verhindert, dass laute Signale verzerrt werden, wobei leise Passagen des Sprachsignals noch deutlich verstärkt werden können.
Figur 1b zeigt das oben beschriebene Hard Clipper-Prinzip.
Figur 2b zeigt die Wirkung des Hard Clippers bei v=1 und v=10. Hier treten schon bei -20 dB starke Verzerrungen auf.
Figur 3b schließlich zeigt die Wirkung des Hard Clippers bei einem Zeitsignal.

**Patentansprüche**

1. Verfahren zur Begrenzung bzw. Reduktion der Dynamik von Audiosignalen, insbesondere menschlichen Sprachsignalen, bei Audio-Endgeräten, insbesondere bei Telekommunikations (=TK)-Endgeräten für die Übertragung von akustischen Nutzsignalen, bei dem ein Eingangssignal x derart behandelt wird, dass ein festgelegter maximaler Grenzwert $y_{max}$ für ein Ausgangssignal y aus dem Endgerät nicht überschritten wird, und bei dem ein vorgebbarer konstanter Verstärkungswert v eingestellt wird, wobei für $v \leq 1$ das Eingangssignal x mit einem Nominalpegel mit maximaler Amplitude $\leq y_{max}$ verzerrungsfrei als Ausgangssignal y wiedergegeben wird, und wobei für v = const > 1 eine Verzerrung der Signale auftritt,
**dadurch gekennzeichnet,**
**dass** in einem ersten Schritt (a) das Eingangssignal x in seiner Dynamik auf einen Zwischenwert $y_1 < x$ komprimiert

wird, und dass in einem darauf folgenden zweiten Schritt (b) das mit dem konstanten Verstärkungswert v verstärkte Ausgangssignal $y = v \cdot y_1$ gebildet wird.

2. Verfahren nach Anspruch 1, **dadurch gekennzeichnet, dass** der Zwischenwert $y_1$ gebildet wird aus $y_1 = x \, v^{-1} \cdot f$ (cf), wobei f(cf) eine Funktion eines dynamischen Verstärkungsfaktors cf ist, der in Abhängigkeit vom Eingangssignal x und dem konstanten Verstärkungswert v berechnet wird.

3. Verfahren nach Anspruch 2, **dadurch gekennzeichnet, dass** aus dem Eingangssignal x ein Kurzzeitmittelwert sam(x) gebildet wird, und dass

    für $v \leq 1$ der dynamische Verstärkungsfaktor cf berechnet wird als
        cf = 1/v,
    für $v > 1$ der dynamische Verstärkungsfaktor cf berechnet wird als
        $cf = 1/(v^2 \cdot sam(x))$
    und daraus jeweils das Ausgangssignal y = x f(cf) gebildet wird.

4. Verfahren nach Anspruch 2, **dadurch gekennzeichnet, dass** aus dem Eingangssignal x ein Kurzzeitmittelwert sam(x) gebildet wird, und dass

    für $v > 1$ der dynamische Verstärkungsfaktor cf berechnet wird als
        $cf = 1/(v^2 \cdot sam(x))$
    und daraus jeweils das Ausgangssignal y = x f(cf) gebildet wird, und für $v \leq 1$ das Ausgangssignal y direkt bestimmt wird aus
        $y = v \cdot x.$

5. Verfahren nach einem der Ansprüche 2 bis 4, **dadurch gekennzeichnet, dass** aus dem Eingangssignal x ein Kurzzeitmittelwert sam(x) gebildet wird, und dass

    für $sam(x) \geq 1/v$ der dynamische Verstärkungsfaktor cf berechnet wird als      cf = 1/v,

    für $sam(x) < 1/v$ der dynamische Verstärkungsfaktor cf berechnet wird als      $cf = 1/( v^2 \cdot sam(x)^n)$,
    wobei $|n| \in \aleph \neq 0$

    und daraus jeweils das Ausgangssignal y = x f(cf) gebildet wird.

6. Verfahren nach Anspruch 3, **dadurch gekennzeichnet, dass** das Eingangssignal x in äquidistanten Zeitschritten T jeweils zu Zeitpunkten k mit einer Abtastfrequenz $f_A = 1/T$ abgetastet wird, und dass die Funktion f(cf) als geglätteter Verstärkungswert cg(k) berechnet wird gemäß

$$f(cf) = cg(k) = \begin{cases} cf & \text{für } sam(x) > 1/v \\ cf(k) \cdot ak + cg(k\text{-}1) \cdot bk & \text{für } cf < cg \\ cf(k) \cdot al + cg(k\text{-}1) \cdot bl & \text{für } cf \geq cg \end{cases}$$

wobei $ak = 1 - bk = 1 - e^{-T/\tau_k}$, mit einer Zeitkonstanten $\tau_k < t_{max}$
und $al = 1 - bl = 1 - e^{-T/\tau_l}$, mit einer Zeitkonstanten $\tau_l > t_{min}$.

7. Verfahren nach Anspruch 3, **dadurch gekennzeichnet, dass** das Eingangssignal x in äquidistanten Zeitschritten T jeweils zu Zeitpunkten k mit einer Abtastfrequenz $f_A = 1/T$ abgetastet wird, und dass die der Kurzzeitmittelwert sam(x(k)) berechnet wird gemäß

$$sam(x(k)) = \begin{cases} x(k) \cdot \alpha k + sam(x(k-1)) \cdot \beta k & \text{für } x(k) > sam(x(k)) \\ x(k) \cdot \alpha l + sam(x(k-1)) \cdot \beta l & \text{für } x(k) \leq sam(x(k)) \end{cases}$$

wobei $\alpha k = 1 - \beta k = 1 - e^{-T/\tau_k}$, mit einer Zeitkonstanten $\tau_k < t_{max}$
und $\alpha l = 1 - \beta l = 1 - e^{-T/\tau_l}$, mit einer Zeitkonstanten $\tau_l > t_{min}$.

8. Servereinheit zur Ausführung des Verfahrens nach einem der Ansprüche 1 bis 7.

9. Prozessorbaugruppe, insbesondere digitaler Signalprozessor (=DSP) zur Ausführung des Verfahrens nach einem der Ansprüche 1 bis 7.

10. Programmierbare Gate-Array-Baugruppe zur Ausführung des Verfahrens nach einem der Ansprüche 1 bis 7.

Fig. 1a

Fig. 1b

Fig. 2a

Fig. 2b

Fig. 3a

Fig. 3b